# EUROPÄISCHE PATENTANMELDUNG

(11) **EP 1 517 361 A2**
(43) Veröffentlichungstag der Anmeldung: **23.03.2005**
(21) Anmeldenummer: 04022111.1
(22) Anmeldetag: 17.09.2004
(51) Int. Cl.: H01L 21/336, H01L 29/78, H01L 29/786, H01L 29/08, H01L 29/36

(54) **Verfahren zur Herstellung eines MOS-Transistors mit einer Driftregion, die einen Graben aufweist**

(30) Priorität: 19.09.2003 DE 10345347
(71) Anmelder: ATMEL Germany GmbH, 74072 Heilbronn (DE)
(72) Erfinder: Dudek, Volker, Dr., 74336 Brackenheim (DE); Graf, Michael, Dr., 71397 Leutenbach (DE)

(57) **Zusammenfassung**

Vorgestellt wird ein Verfahren zur Herstellung eines DMOS-Transistors in einem Halbleiterkörper (10), mit einer grabenförmigen Driftregion (29, 30, 33), die einen Sourceseitigen Seitenbereich (29), einen sich in lateraler Richtung erstreckenden Bodenbereich (30) und einen Drain-seitigen Seitenbereich (33) aufweist. Das Verfahren zeichnet sich dadurch aus, dass in dem Bodenbereich (30) ein in lateraler Richtung (36) weisender Gradient einer Dotierstoffkonzentration durch wenigstens eine von oben erfolgende Implantation eines Dotierstoffs erzeugt wird, die nur einen Teilbereich (40) des Bodenbereichs (30) erfasst.

## Beschreibung

Die Erfindung betrifft ein Verfahren zur Herstellung eines DMOS-Transistors in einem Halbleiterkörper, mit einer grabenförmigen Driftregion, die einen Source-seitigen Seitenbereich, einen sich in lateraler Richtung erstreckenden Bodenbereich und einen Drain-seitigen Seitenbereich aufweist.

Ein solches Verfahren ist aus der DE 101 31 705 A1 bekannt.

Ein DMOS-Transistor zeichnet sich gegenüber einem herkömmlichen MOS Transistor (Metal-Oxid Semiconductor Transistor) dadurch aus, dass zwischen einer Kante eines Steuer-Gates und einem Drain-Bereich des Transistors eine Driftregion vorgesehen ist, d. h. eine Region, in der die Bewegung der Ladungsträger nur durch ein zwischen den gegenüberliegenden Enden der Region herrschendes elektrisches Feld bewirkt wird. In einem lateralen DMOS-Transistor (LDMOS Transistor) erstreckt sich die Driftregion in lateraler Richtung, zwischen der Kante des Steuer-Gates und dem davon in lateraler Richtung entfernten Drain-Bereich.

DMOS-Transistoren finden als Hochspannungsbauelemente Anwendung, in denen zwischen dem Drain-Bereich und dem Source-Bereich des Transistors Spannungen, so genannte Drain-Spannungen, von mehr als 100 Volt angelegt werden können.

Es ist bereits aus US 5 539 238 bekannt, DMOS Transistoren mit tiefen Trench-Strukturen zu erzeugen, wobei dotierte Bereiche, die sich an die Seitenwände und an die Bodenfläche eines Grabens (Trench) anschließen, die sogenannte Driftregion des Transistors darstellen. Durch die teilweise vertikale Ausbildung der Driftregion entlang der Seitenwände des Grabens lässt sich die Länge des Transistors verringern. Nachteilig an dem Verfahren ist, dass bei einer anliegenden Sperrspannung an den Kanten der Trenchstruktur Inhomogenitäten in dem Potentialverlauf auftreten, die zu einer unerwünschten Verringerung der Sperrspannung des Transistors führen. Ferner wird die Gesamtlänge der Driftregion nicht verringert, sondern nur in einen vertikalen und einen lateralen Anteil aufgeteilt. Mit anderen Worten: Der spezifische Einschaltwiderstand Rsp = Rdson/Fläche wird nicht verringert, was aber wünschenswert wäre. Vielmehr lassen sich die Seitenwände nur unzureichend dotieren und der spezifische Einschaltwiderstand Rsp und damit der Flächenverbrauch des Transistors werden unerwünscht erhöht.

Ein weiteres Verfahren ist aus der Druckschrift EP 0 837 509 A 1 bekannt. Nach dieser Schrift wird in einem DMOS Transistor unter einem LOCOS-Oxid eine selbstjustierte Driftregion erzeugt. Nachteilig ist, dass die Dotierung der Driftregion vor der Oxidation eingebracht wird und sich der Anteil des Dotierstoffes, der bei der Oxidation in das Oxid eindiffundiert, nur ungenau bestimmen lässt. Ferner bewirkt die hohe Temperaturbelastung bei der Oxidation eine sehr breite Dotierstoffverteilung, die ihrerseits eine größere Ungenauigkeit in der Dotierstoffkonzentration verursacht. Des Weiteren ist unterhalb des Oxides eine große Siliziumdicke erforderlich, um mittels des sogenannten, per se bekannten, "RESURF" Effekts die Sperrspannung zu erhöhen. Die Abkürzung "RESURF" steht für "reduced surface field". Die Feldreduzierung ergibt sich aus einer verringerten Ladungsträgerkonzentration in der Driftregion. Insgesamt werden durch die Prozessstreuungen die unerwünschten Streuungen in den elektrischen Parametern des Transistors vergrößert.

Ein vorrangiges Ziel in der Entwicklung auf dem Gebiet der DMOS Transistoren besteht in der weiteren Verringerung der Dimensionen von Strukturen, die bei einer anliegenden Sperrspannung niedrige Feldstärken aufweisen, um eine Generation von Ladungsträgern, die zu einem Durchbruch innerhalb des Bauelementes führen, zu vermeiden.

Ein weiteres Ziel der Entwicklung bei den DMOS Transistoren besteht darin, einen niedrigen spezifischen Einschaltwiderstand Rsp zu erzielen. Damit soll bei integrierten Schaltungen, bei denen die DMOS Transistoren einen wesentlichen Anteil an der Gesamtchipfläche beanspruchen, der Flächenverbrauch der integrierten Schaltungen reduziert werden.

Der vorliegenden Erfindung liegt daher die Aufgabe zu Grunde, ein Verfahren anzugeben, mit dem sich DMOS Transistoren auf kleiner Fläche für hohe Sperrspannungen herstellen lassen.

Diese Aufgabe wird bei einem Verfahren der eingangs genannten Art dadurch gelöst, dass in dem Bodenbereich ein in lateraler Richtung weisender Gradient einer Dotierstoffkonzentration durch wenigstens eine von oben erfolgende Implantation eines Dotierstoffs erzeugt wird, die nur einen Teilbereich des Bodenbereichs erfasst.

Bisher wurden die Dotierungsprofile innerhalb der Driftregion in lateraler Richtung gleichmäßig durch Implantationen und/oder Drives erzeugt. Auf diese Weise kann das Dotierungsprofil zwar in vertikaler Richtung genau eingestellt werden. Eine Modifikation der lateralen Konzentration kann auf diese Weise jedoch nicht erreicht werden. Zur Erhöhung der Durchbruchspannung und der Reduktion des Widerstands ist es jedoch besser, die Driftregion auf der Drain-Seite höher zu dotieren als auf der Source-Seite. Ebenso kann es vorteilhaft sein, dass die Mitte der Driftregion höher dotiert ist als die Ränder. Dies wird mit dem beschriebenen Verfahren erreicht.

Ein wesentlicher Vorteil des neuen Verfahrens besteht in einer noch weitergehenden Optimierungsmöglichkeit innerhalb eines Parameterfeldes, das im Wesentlichen von dem spezifischen Einschaltwiderstand Rsp, der Durchbruchspannung Vbreak und der Größe und Form der SOA (safe-operation-area) Fläche bestimmt wird. Diese weitergehende Optimierungsmöglichkeit ergibt sich aus der Erzeugung des lateralen Gradienten der Dotierstoffkonzentration im Bodenbereich der grabenförmigen Struktur. Damit lassen sich, gegebenenfalls in Verbindung mit unterschiedlichen Konzentrationen des Dotierstoffes in der Source-seitigen Seitenwand gegenüber der Drain-seitigen Seitenwand, die zusammen mit dem Bodenbereich die Driftregion des Transistors definieren, DMOS-Transistoren mit einer weiter verringerten Gesamtfläche erzeugen. Ferner lässt sich mittels einer unterschiedlich hohen Dotierstoffkonzentration entlang des Bodens der grabenförmigen Struktur das Einsetzen und die Stärke des RESURF Effekts besonders vorteilhaft optimieren.

Da ein Gradient im Dotierungsprofil des Bodens wegen des RESURF Effekts zumindest in Verbindung mit dem Dotierungsverlauf in der Source-seitigen Seitenwand einen wesentlichen Einfluss auf die Durchbruchspannung sowohl im sperrenden als auch im eingeschalteten Zustand hat, während der Drain-seitige Dotierstoffverlauf wesentlichen Einfluss auf den Einschaltwiderstand Rdson hat, ist eine Anpassung der Dotierprofile an die elektrischen Anforderungen auch entlang des Bodens der grabenförmigen Struktur besonders vorteilhaft.

Es ist bevorzugt, dass der Bodenbereich in der Nähe der Drain-seitigen Seitenwand höher dotiert wird als der Bodenbereich in der Nähe der Source-seitigen Seitenwand.

Durch diese Ausgestaltung läst sich ein weiter verringerter Einschaltwiderstand Rsp erzielen. Alternativ ist bevorzugt, dass ein zentraler Bereich des Bodenbereichs höher dotiert wird als randseitige Teilbereiche in der Nähe der Drain-seitigen Seitenwand und/oder der Source-seitigen Seitenwand, weil dies tendenziell eine Erhöhung der Sperrspannung zur Folge hat.

Bevorzugt ist auch, dass vor der von oben erfolgenden Implantation eines Dotierstoffs in einen Teilbereich des Bodenbereiches ein komplementärer Teilbereich des Bodenbereichs durch eine Maske abgedeckt wird. Dabei ist weiter bevorzugt, dass ein selbstjustierender Maskenprozessschritt verwendet wird. Eine weitere bevorzugte Ausgestaltung zeichnet sich dadurch aus, dass die Maske durch eine Strukturübertragung durch Lithografie und Ätzen erzeugt wird. Bevorzugt ist auch, dass cin Positiv oder ein Negativ der Maske durch eine Photolackschicht definiert wird.

Durch diese Merkmale lassen sich Dotierstoffkonzentrationsgradienten mit einer gängigen Maskentechnologie mit reproduzierbar hoher Genauigkeit erzeugen, wobei die gängigen Maskenschritte problemlos in übliche DMOS-Fertigungsverfahren integriert werden können.

Ferner ist bevorzugt, dass das Verfahren nach einer zu einer Definition der Driftregion erfolgenden Öffnung einer Hartmaske durchgeführt wird.

Zu diesem Zeitpunkt lassen sich die erforderlichen Verfahrensschritte ohne Änderung vorhergehender oder nachfolgender Verfahrensschritte in übliche Herstellungsverfahren integrieren.

Bevorzugt ist auch, dass die grabenförmige Struktur in einem Halbleiterkörper mit einem ersten Wannenbereich eines ersten Leitfähigkeitstyps und einem zweiten Wannenbereich eines zweiten Leitfähigkeitstyps teilweise oder vollständig innerhalb des zweiten Wannenbereichs erzeugt wird.

Je weiter sich die zweite Wanne in Richtung der Source ausdehnt, desto stärker verringert sich der spezifische Einschaltwiderstand Rsp, da der Bodenbereich der grabenförmigen Struktur und die zweite Wanne die gleiche Polarität der Dotierung aufweisen. Gleichzeitig weist der Transistor eine hohe Durchbruchspannung auf, da die Konzentrationen der Dotierungen der ersten und der zweiten Wanne wesentlich geringer sind als die Konzentrationen der Bereiche von Source und Drain. Ferner lassen sich beide Wannen in einem einzigen Maskenschritt selbstjustiert durch eine LOCOS-Oxidation herstellen. Dabei ist es vorteilhaft, die erste Wanne tiefer und länger einzutreiben, um unterhalb der grabenförmigen Struktur mittels eines lateralen PN-Übergangs einen RESURF Effekt zur erzeugen, der die Durchbruchspannung erhöht.

Femer ist bevorzugt, dass ein Abstand zwischen der Drain-seitigen Seitenwand der grabenförmigen Struktur und einem Drain-Bereich erzeugt wird, der vorzugsweise zwischen 0.5 Mikrometer und 4.0 Mikrometer liegt.

Untersuchungen der Anmelderin haben gezeigt, dass sich im Bereich des Durchbruchs des Transistors eine Symmetrisierung erzielen lässt, wenn der Abstand zwischen der Drain-seitigen Seitenwand der grabenförmigen Struktur und dem Drain-Bereich innerhalb dieser Grenzen liegt. Hierbei wird mit dem zusätzlichen Drain-seitigen Widerstand durch den auftretenden Spannungsabfall eine lokale Überhöhung der Stromdichte unterdrückt. Insbesondere in Verbindung mit einem Querregler lassen sich mit derartigen Transistoren vorteilhafte ESD-Schutzstrukturen herstellen

Eine weitere bevorzugte Ausgestaltung sieht vor, dass in den Seitenwänden und in dem Bodenbereich der grabenförmigen Struktur eine Dotierung auf einem höheren Konzentrationswert als im ersten Wannenbereich erzeugt wird.

Durch diese Ausgestaltung wird ein erhöhter RESURF Effekt und damit eine Erhöhung der Sperrspannung bei gleichzeitiger Verringerung des spezifischen Einschaltwiderstand Rsp erzielt. Eine gleiche Dotierstoffkonzentration in der Source-seitigen Seitenwand und in der Drain-seitigen Seitenwand der grabenförmigen Struktur vereinfacht dagegen die Einbringung des Dotierstoffs und erhöht den spezifischen Einschaltwiderstand Rsp nur geringfügig, da sich die einzelnen Konzentrationen der Dotierstoffe summieren, sofern der Drain-Bereich unmittelbar an der Seitenwand der grabenförmigen Struktur beginnt und die Eindringtiefe der Drain-seitigen Dotierung im Bereich der Tiefe der grabenförmigen Struktur liegt.

Bevorzugt ist ferner, dass ein Aspekt-Verhältnis der grabenförmigen Struktur, also das Verhältnis von Grabenbreite zu Grabentiefe, oberhalb von 0.5 bei einer Breite der grabenförmigen Struktur in einem Bereich zwischen 0.5 Mikrometer und 4.0 Mikrometer liegt.

Untersuchungen der Anmelderin für unterschiedliche Dotierstoffkonzentration für Wand und Boden haben gezeigt, dass es vorteilhaft ist, wenn das Aspekt-Verhältnis der grabenförmigen Struktur und die Absolutwerte der Breite innerhalb des durch die angegebenen Werte definierten Intervalls liegen.

Weiter ist bevorzugt, dass die grabenförmige Struktur im Bodenbereich eine geringere Breite als an einer Oberfläche aufweist, sich also nach unten verjüngt.

Durch diese Ausgestaltung lassen sich Feldstärkeüberhöhungen an Kanten der grabenförmigen Struktur unterdrücken.

Ferner ist bevorzugt, dass die grabenförmige Struktur mittels einer STI Ätzung erzeugt und mit einem isolierenden Material, vorzugsweise mittels eines Oxids, aufgefüllt wird.

Da die Dotierung erst nach der Siliziumätzung mit einer niedrigen Implantationsenergie erfolgt und anschließend kein dickes LOCOS-Oxid mit einer hohen Temperaturbelastung erzeugt wird, lassen sich unterhalb des Bodens der grabenförmigen Struktur auf einer geringen vertikalen Strecke räumlich hochdotierte Bereiche erzeugen, die einen vergrabenen Strompfad mit einem geringem Widerstand ausbilden. Des Weiteren wird der Flächenverbrauch der Transistoren verringert, da sich durch die Selbstjustierung in Verbindung mit einer gleichzeitig reduzierten Temperaturbelastung gegenüber einer LOCOS-Oxidation die Prozessstreuungen der in die grabenförmigen Struktur eingebrachten Dotierstoffprofile reduzieren.

Alternativ ist bevorzugt, dass die grabenförmige Struktur mittels einer LOCOS-Oxidation erzeugt wird.

In diesem Fall wird die grabenförmige Struktur mittels einer V-Grabenätzung erzeugt und in einer nachfolgenden LOCOS-Oxidation, die wegen der geringeren Temperaturbelastung vorzugsweise durch eine Hochdruckoxidation hergestellt wird, aufgefüllt. Die Dotierung der Seitenwände und des Bodens wird vor der LOCOS-Oxidation durchgeführt, wobei die eingebrachte Dosis der Dotierstoffe um den Anteil, der bei der Oxidation in das Oxid eindiffundiert, erhöht wird.

Bevorzugt ist auch, dass der Halbleiterkörper unterhalb einer Oberflächenschicht aus einem halbleitendem Substrat eine isolierende Zwischenschicht aufweist und der DMOS Transistor in der Oberflächenschicht aus dem halbleitenden Substrat erzeugt wird.

Eine weitere bevorzugte Ausgestaltung zeichnet sich dadurch aus, dass die Dicke der Oberflächenschicht aus dem halbleitenden Substrat unterhalb der grabenförmigen Struktur in einem Bereich zwischen der Hälfte und einem Faktor Fünf der Tiefe der grabenförmigen Struktur liegt.

Ferner ist bevorzugt, dass das Verfahren innerhalb eines Verfahrens zur Herstellung eines DMOS Transistors mit einem Halbleiterkörper verwendet wird, der eine Oberflächenschicht aus einem halbleitendem Substrat mit einem Source-Bereich und einem Drain-Bereich eines zweiten Leitfähigkeitstyps und einen ersten, den Source-Bereich umschließenden Wannenbereich eines ersten Leitfähigkeitstyps, und einen zweiten, den Drain-Bereich umschließenden Wannenbereich des zweiten Leitfähigkeitstyps aufweist, wobei auf der Oberfläche der Oberflächenschicht aus einem halbleitendem Substrat des Halbleiterkörpers ein Gate -Bereich ausgebildet ist, der sich von dem Source-Bereich ausgehend vollständig über den ersten Wannenbereich erstreckt, wobei die grabenförmige Struktur ausgehend von der Oberfläche des Halbleiterkörpers in der Oberflächenschicht aus dem halbleitenden Substrat erzeugt wird, und im Bodenbereich der grabenförmigen Struktur eine Dotierung des zweiten Leitfähigkeitstyps erzeugt wird, und in der Source-seitigen Seitenwand der grabenförmigen Struktur eine Dotierung des zweiten Leitfähigkeitstyps mit einem zweiten Konzentrationswert erzeugt wird, und in der Drain-seitigen Seitenwand der grabenförmigen Struktur eine Dotierung des zweiten Leitfähigkeitstyps mit einem dritten Konzentrationswert erzeugt wird.

Untersuchungen der Anmelderin haben gezeigt, dass nach dem erfindungsgemäßen Verfahren, insbesondere nach den letztgenannten Ausgestaltungen hergestellte DMOS-Transistoren besonders zur Herstellung von hochsperrenden integrierten Schaltungen, die einen Ausgangstreiber zum Ansteuern von induktiven Lasten aufweisen, geeignet sind. Dies gilt in verstärktem Maße für DMOS-Transistoren, die aus einem Silizium-Wafer mit einer isolierenden Zwischenschicht, einem sogenannten "silicon on insulator" (SOI)-Wafer hergestellt worden sind.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: einen Ausschnitt aus einem SOI-Wafer, wie er in einem Ausführungsbeispiels eines erfindungsgemäßen Verfahrens als Basis benutzt wird;
- Fig. 2: den SOI-Wafer aus der Fig. 1 in einem späteren Stadium des Verfahrens;
- Fig. 3: einen Maskenschritt zur Erzeugung eines Dotierstoffkonzentrationsgradienten im Boden einer Driftregion; und
- Fig. 4: einen Querschnitt der resultierenden Dotierungsschichten.

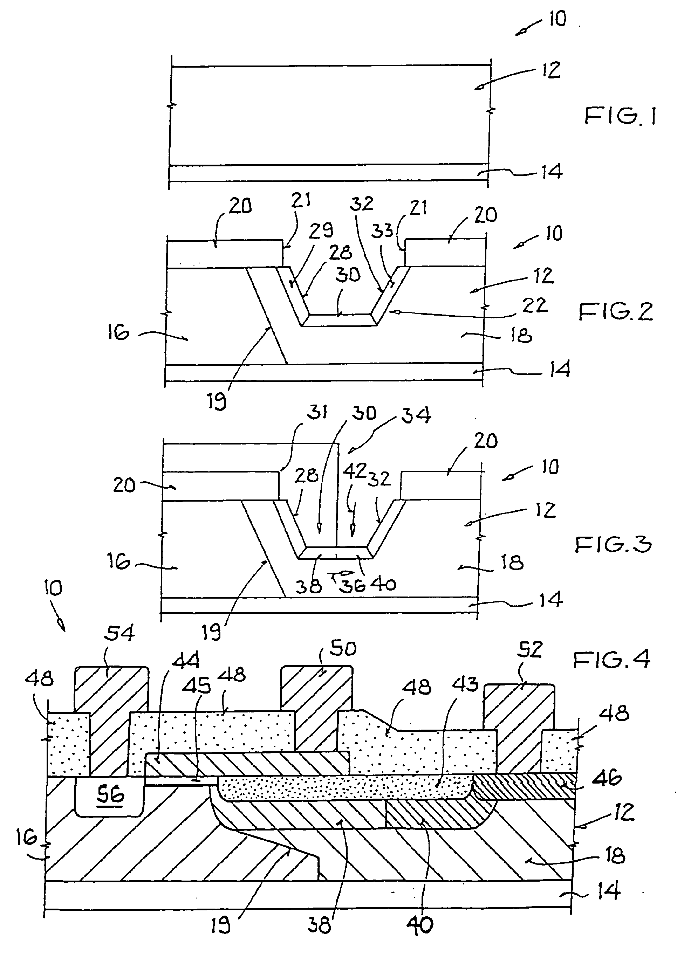

Die Figur 1 zeigt einen Ausschnitt eines Halbleiterkörpers 10, der ein halbleitendes Substrat 12 auf einer isolierenden Zwischenschicht 14 aufweist. Ein typisches Beispiel eines solchen Halbleiterkörpers 10 wird durch einen "silicon on insulator"-Wafer (SOI)-Wafer repräsentiert. Dabei wird die isolierende Zwischenschicht 14 in der Regel als Siliziumdioxid-Schicht realisiert sein. Zur Herstellung eines DMOS-Transistors wird zunächst ein erster Wannenbereich 16 und ein zweiter Wannenbereich 18 in dem Silizium-Halbleiterkörper 10 erzeugt. Beide Wannenbereiche 16, 18 werden dabei so dotiert, dass sich in ihnen unterschiedliche Leitfähigkeitstypen einstellen. Für eine P-Leitfähigkeit wird der erste Wannenbereich 16 beispielsweise mit Akzeptoren (dreiwertige Substitutionsstörstellen, bspw. Bor-Atome) dotiert. Ähnlich wird der zweite Wannenbereich 18 zur Erzeugung einer N-Dotierung mit Donatoren (fünfwertige Substitutionsstörstellen wie Arsen oder Phosphor) dotiert.

Die Wannenbereiche 16, 18 werden lithografisch mit Masken in einer Fotolackschicht definiert. Ein nasschemischer Ätzschritt öffnet ein Oxid in den Lackfenstern bis zur Siliziumoberfläche. Nach einem Belegen der freien Siliziumoberfläche mit einem Streuoxid erfolgt eine Dotierung durch Ionenimplantation. An den Implantationsschritt schließt sich eine Ausheil- und Aktivierungsprozedur an, bei der die Dotierstoff-Atome tief eindiffundieren und aktiviert werden. Beim Beispiel eines SOI-Wafers werden die Dotierstoff-Atome durch den Diffusionsprozess bevorzugt bis zur isolierenden Oxidschicht 14 hinuntergetrieben. Dabei ist es vorteilhaft, den ersten Wannenbereich 16 länger einzutreiben, um unterhalb einer später zu erzeugenden grabenförmigen Struktur einen lateralen PN-Übergang zu erzielen, der einen Resurf-Effekt verstärkt und damit die Durchbruchspannung in erwünschter Weise erhöht. Die Figur 2 zeigt einen solchen PN-Übergang 19, bei dem die laterale Komponente aber nur schwach ausgeprägt ist.

In einem weiteren Prozessschritt wird in einer Art Hartmaske 20, die beispielsweise aus einem Nitrit und/oder einem Oxid besteht, eine Öffnung 21 freigeätzt. Dabei wird das Ätzfenster wieder durch eine Fotolackmaske definiert. Anschließend wird durch die Öffnung 21 ein Dotierstoff (Donatoren) implantiert und durch einen thermischen Ausheil-und Aktivierungsschritt (Drive) durch einen Diffusionsprozess in den Halbleiterkörper 10 eingetrieben, so dass sich nach dem Eintreiben ein Dotierstoffprofil 22 im Halbleiterkörper 10 unterhalb der Öffnung 21 einstellt.

Um unterschiedliche Konzentrationen in seitlichen Randbereichen des dotierten Bereichs 22 zu erzeugen, kann die Implantation der Dotierstoftatome unter einem Tilt-Winkel von beispielsweise 60 ° erfolgen. In einem nachfolgenden Prozessschritt wird der dotierte Bereich 22 gewissermaßen ausgehöhlt. Das heißt, es wird eine Grabenstruktur 26 erzeugt, was beispielsweise durch eine anisotrope STI-Ätzung (shallow trench isolation) erreicht werden kann. Bei der "shallow trench isolation"-Technologie werden durch einen anisotropen Ätzprozess Gräben zwischen den mit einer Nitridschutzschicht bedeckten Bereichen erzeugt und später mit einem isolierenden Material wie Siliziumdioxid oder Polysilizium aufgefüllt. Dabei gilt ein Graben bei einem Aspekt-Verhältnis, also einem Verhältnis von Grabentiefe zu Grabenbreite, das kleiner als eins ist, als flach im Sinne der namensgebenden Beschreibung. Mit anderen Worten: Ein flacher Graben ist breiter als er tief ist.

Nach dem Erzeugen der grabenförmigen Struktur 26 bleiben von dem vorher erzeugten dotierten Bereich 22 je ein Source-seitiger Seitenbereich 29, ein Bodenbereich 30 und ein Drain-seitiger Seitenbereich 33 übrig.

An die Erzeugung der grabenförmigen Struktur 26 schließen sich weitere Schritte zur Definition der gewünschten Dotierstoffprofile in den Seitenbereichen 29, 33 und dem Bodenbereich 30 der grabenförmigen Struktur 26 an. Um einen definierten Anfangszustand für die Erzeugung eines lateralen Dotierstoffkonzentrations-Gradienten im Bodenbereich 30 zu schaffen, kann die STI-Ätzung soweit hinunter getrieben werden, dass eventuell noch vorhandener Dotierstoff im Bodenbereich 30 vollständig entfernt wird. Die bis zu diesem Zeitpunkt eingebrachte Dotierung bestimmt dann lediglich die Dotierstoffkonzentration in den Seitenwänden 28, 32, nicht aber die Dotierung in dem Bodenbereich 30. Um den Bodenbereich 30 ohne große Veränderung der Dotierung der Seitenbereich 28 und 32 dotieren zu können, erfolgt zunächst die Bildung einer Schutzschicht auf den Seitenwänden 28 und 32 durch Belegung der Seitenwände mit einem dünnen Streuoxid.

Durch den Oxidationsschritt wird gleichzeitig der aus dem ersten Implantationsschritt verbleibende Dotierstoff von den Seitenwänden 28 und 32 in tieferliegende Bereiche eindiffundiert, wobei sich Source-seitig der erste Bereich 29 mit einer ersten Dotierstoffkonzentration und Drain-seitig der zweite Bereich 33 mit einer zweiten Dotierstoftkonzentration ausbildet. Die erste Dotierstoffkonzentration weicht insbesondere dann von der zweiten Dotierstoffkonzentration ab, wenn die Implantation unter einem Tilt-Winkel erfolgt ist, bei der eine Implantation beispielsweise in Richtung des Drain-seitigen Bereiches 33 bevorzugt wurde.

Im Folgenden wird mit Bezug auf die Figur 3 beschrieben, wie in einem Bodenbereich 30 eine unter der Oberfläche des Bodenbereichs 30 liegender Bodenbereich 30 mit einem lateralen Dotierstoffkonzentrationsgradienten erzeugt wird.

Dazu wird zunächst eine Fotolackmaske 34 erzeugt, die den Bodenbereich 30 nur teilweise abdeckt. Durch senkrecht von oben erfolgendes Implantieren einer vorbestimmten Dotierstoffmenge ergibt sich ein Source-seitiger Bodenbereich 38 sowie ein Drain-seitiger Bodenbereich 40, wobei sich beide Teilbereiche 38, 40 in ihrer Dotierstoffkonzentration unterscheiden. Der zusätzliche Maskenschritt wird an die geöffnete Hartmaske zur Definition der Driftregion angeknüpft. Im Falle eines LOCOS-Prozesses wird, noch vor der LOCOS-Oxidation, mit einer Implantationsmaske ein Bereich der Driftregion zusätzlich implantiert. Im Falle des STI-Prozesses wird vor oder nach einer Bodenimplantation der Driftregion ein Bereich der Driftregion zusätzlich implantiert. In beiden Fällen wird also durch eine Maske ein Teil der Driftregion abgedeckt und der offene Bereich zusätzlich dotiert. Im weiteren Prozess würde dann jeweils rechts das Drain-Gebiet und links das Source-Gebiet entstehen.

Bei der in der Figur 3 dargestellten Konstellation ergibt sich ein Dotierstoffkonzentrationsgradient 36, der aus dem zunächst abgedeckten Bodenbereich 38 zum zunächst nicht abgedeckten Bodenbereich 40 weist, in den eine höhere Dotierstoffkonzentration implantiert wurde. Wie bereits bemerkt, soll die Implantierung des Dotierstoffs für den Bodenbereich senkrecht von oben, also parallel zu dem Pfeil 42 erfolgen, der diese Implantationsrichtung angibt. Es versteht sich, dass durch weitere Masken und Implantationsschritte, bei denen eine Photomaske 34 jeweils lateral über dem Bodenbereich 30 verschoben wird, eine fast beliebig feine Schrittweite einer lateralen Dotierstoffvariation im Bodenbereich 30 erzielt werden kann.

Vorteilhaft wirkt sich dabei aus, dass eine Seite der Öffnung jeweils selbstjustiert auf einer Kante 31 der Hartmaske 20 liegt. Dabei ist es nicht zwingend, dass die Maske aus Photolack besteht; sie kann auch aus anderen Materialien bestehen. Es versteht sich weiter, dass der Gradient auch antiparallel zum Pfeil 36 eingestellt werden kann. Als weitere Alternative ist es möglich, einen zentralen Teilbereich des Bodenbereiches 30 stärker zu dotieren als Randregionen zwischen einem solchen zentralen Teilbereich und den Seitenwänden 28, 32. Mit anderen Worten: Anstelle einer zusätzlichen Dotierung der Drain-Seite kann auch die Mitte der Driftregion zusätzlich dotiert werden.

Durch weitere, an sich bekannte Prozessschritte wird die unter Bezug auf die Figuren 1 - 3 erläuterte Struktur zu einem DMOS-Transistor weiterverarbeitet, wie er in der Figur 4 dargestellt ist. Dazu wird beispielsweise zunächst die noch offene grabenförmige Struktur 26 mit einem isolierenden Material, beispielsweise mit einem CVD-Oxid 43 (CVD = chemical vapor deposition) aufgefüllt und die Oberfläche der grabenförmigen Struktur 26 durch einen CMP-Schritt (CMP = chemical mechanical polishing) planarisiert. Das Füllen der grabenförmigen Struktur wird bevorzugt gemeinsam mit dem Füllen weitererer Trench-Strukturen, die Bauelementeboxen definieren, durchgeführt.

In weiteren Prozessschritten werden Gate-Bereiche 44, Drain-Bereiche 46 und Source-Bereiche 56 definiert, mit einer passivierenden Oxidschicht 48 versehen und über metallische Kontakte 50, 52 und 54 mittels eines Kontaktfensterprozesses an ein Leiterbahnensystem angeschlossen. Durch die Verwendung eines SOI-Wafer mit einer Trenchisolierung liegen die hergestellten Transistoren in einzelnen voneinander isolierten Bauelementboxen.

Der Drain-Bereich 46 wird bevorzugt so definiert, dass er sich unmittelbar an die Drain-seitige Seitenwand 32 der grabenförmigen Struktur 26 anschließt. Als Folge summieren sich die Dotierstoffkonzentrationen im Drain-seitigen zweiten Bereich 33 und im Drain-Bereich 46. Der Source-Bereich 56 wird bevorzugt so definiert, dass er von dem P-Wannenbereich 16 eingeschlossen wird, wobei sich die P-Wanne 16 in lateraler Richtung unmittelbar an die N-Wanne 18 anschließt.

Die Richtung der Schraffierung in der Figur 4 gibt jeweils die Polarität der Dotierung an. Bereiche, die eine negative Polarität aufweisen, sind mit Strichen von links oben nach rechts unten schraffiert und Bereiche, die eine positive Polarität aufweisen, sind mit Strichen von links unten nach rechts oben schraffiert. Es versteht sich, dass die jeweiligen Polaritäten auch vertauscht werden können. Ferner wird die Höhe der Konzentration des Dotierstoffs in dem jeweiligen Bereich durch die Dichte der Schraffur wiedergegeben.

Letztlich wird durch eine Prozessfolge zur Herstellung von DMOS-Transistoren dargestellt, in der, basierend auf einem bekannten Prozessablauf, zusätzlich ein gewünschtes laterales Konzentrationsprofil in einer Driftregion durch eine oder mehrere von oben erfolgende Implantationen erzeugt wird. Mit derartigen Prozessfolgen lassen sich gleichzeitig N- und P-DMOS-Transistoren für eine integrierte Schaltung herstellen.

Das erfindungsgemäße Verfahren kann auch zur Herstellung von DMOS-Transistoren in bulk-Substraten verwendet werden. Bevorzugt wird der DMOS Transistor jedoch in der Oberflächenschicht aus einem halbleitendem Substrat eines Wafers mit einer isolierenden Zwischenschicht erzeugt. Es ist dabei vorteilhaft, wenn die Dicke der unterhalb der grabenförmigen Struktur verbleibenden Oberflächenschicht aus einem halbleitendem Substrat (12) zwischen der Hälfte und einem Faktor Fünf der Tiefe der grabenförmigen Struktur liegt. Ferner ist es vorteilhaft, wenn die beiden Wannenbereiche 16, 18 unmittelbar an die isolierende Zwischenschicht 14 anschließen, um die parasitären Kapazitäten zu unterdrücken.

Ein weiterer Vorteil ist, dass die erforderliche Schichtdicke des halbleitenden Substrates 12 im Bereich von wenigen Nanometern liegt, da die Ausbildung eines hochdotierten vergrabenen Kanals im Anschluss an den Boden der grabenförmigen Struktur eine geringe vertikale Ausdehnung aufweist.

## Patentansprüche

1. Verfahren zur Herstellung eines DMOS-Transistors in einem Halbleiterkörper (10), mit einer grabenförmigen Driftregion (29, 30, 33) die einen Source-seitigen Seitenbereich (29), einen sich in lateraler Richtung erstreckenden Bodenbereich (30) und einen Drain-seitigen Seitenbereich (33) aufweist, **dadurch gekennzeichnet, dass** in dem Bodenbereich (30) ein in lateraler Richtung (36) weisender Gradient einer Dotierstoffkonzentration durch wenigstens eine von oben erfolgende Implantation eines Dotierstoffs erzeugt wird, die nur einen Teilbereich (40) des Bodenbereichs (30) erfasst.

2. Verfahren nach Anspruch 1, **dadurch gekennzeichnet, dass** der Bodenbereich (30) in der Nähe einer Drain-seitigen Seitenwand (28) höher dotiert wird als der Bodenbereich (30) in der Nähe einer Source-seitigen Seitenwand (32).

3. Verfahren nach Anspruch 1, **dadurch gekennzeichnet, dass** ein zentraler Bereich des Bodenbereichs (30) höher dotiert wird als randseitige Teilbereiche in der Nähe einer Drain-seitigen Seitenwand (28) und/oder einer Source-seitigen Seitenwand (30).

4. Verfahren nach einem der vorhergehenden Ansprüche, **dadurch gekennzeichnet, dass** vor der von oben erfolgenden Implantation eines Dotierstoffs ein komplementärer Teilbereich (38) des Bodenbereichs (30) durch eine Maske (34) abgedeckt wird.

5. Verfahren nach Anspruch 4, **dadurch gekennzeichnet, dass** ein selbstjustierender Maskenprozessschritt verwendet wird.

6. Verfahren nach Anspruch 5, **dadurch gekennzeichnet, dass** die Maske durch eine Strukturübertragung durch Lithografie und Ätzen erzeugt wird.

7. Verfahren nach Anspruch 5, **dadurch gekennzeichnet, dass** ein Positiv oder ein Negativ der Maske (34) durch eine Photolackschicht definiert wird.

8. Verfahren nach einem der vorhergehenden Ansprüche, **dadurch gekennzeichnet, dass** es nach einer zu einer Definition der Driftregion erfolgenden Öffnung einer Hartmaske (20) durchgeführt wird.

9. Verfahren nach Anspruch 8, **dadurch gekennzeichnet, dass** es vor einer gegebenenfalls stattfindenden LOCOS-Oxidation durchgeführt wird.

10. Verfahren nach einem der vorhergehenden Ansprüche, **dadurch gekennzeichnet, dass** die grabenförmige Driftregion (29, 30, 33) in einem Halbleiterkörper (12) mit einem ersten Wannenbereich (16) eines ersten Leitfähigkeitstyps und einem zweiten Wannenbereich (18) eines zweiten Leitfähigkeitstyps teilweise oder vollständig innerhalb des zweiten Wannenbereichs (18) erzeugt wird.

11. Verfahren nach einem der vorhergehenden Ansprüche, **dadurch gekennzeichnet, dass** ein Abstand zwischen einer Drain-seitigen Seitenwand (32) der grabenförmigen Driftregion (29, 30, 33) und einem Drain-Bereich (46) erzeugt wird, der vorzugsweise zwischen 0.5 Mikrometer und 4.0 Mikrometer liegt.

12. Verfahren nach einem der vorhergehenden Ansprüche, **dadurch gekennzeichnet, dass** in den Seitenwänden (28, 32) und in dem Bodenbereich (30) der grabenförmigen Driftregion (29, 30, 33) eine Dotierung auf einem höheren Konzentrationswert als im ersten Wannenbereich (16) erzeugt wird.

13. Verfahren nach einem der vorhergehenden Ansprüche, **dadurch gekennzeichnet, dass** ein Aspekt-Verhältnis der grabenförmigen Driftregion (29, 30, 33) oberhalb von 0.5 bei einer Breite der grabenförmijen Struktur in einem Bereich zwischen 0.5 Mikrometern und 4.0 Mikrometern liegt.

14. Verfahren nach einem der vorhergehenden Ansprüche, **dadurch gekennzeichnet, dass** die grabenförmigen Driftregion (29, 30, 33) im Bodenbereich (30) eine geringere Breite als an einer Oberfläche aufweist.

15. Verfahren nach einem der vorhergehenden Ansprüche, **dadurch gekennzeichnet, dass** die grabenförmige Driftregion (29, 30, 33) mit einer STI Ätzung erzeugt und mit einem isolierenden Material, vorzugsweise mit einem Oxid, aufgefüllt wird.

16. Verfahren nach einem der vorhergehenden Ansprüche, **dadurch gekennzeichnet, dass** die grabenförmige Driftregion (29, 30, 33) mit einer LOCOS-Oxidation erzeugt wird.

17. Verfahren nach einem der vorhergehenden Ansprüche, **dadurch gekennzeichnet, dass** der Halbleiterkörper (12) unterhalb einer Oberflächenschicht aus einem halbleitendem Substrat (12) eine isolierende Zwischenschicht (14) aufweist und der DMOS-Transistor in der Oberflächenschicht aus einem halbleitendem Substrat (12) erzeugt wird.

18. Verfahren nach Anspruch 17, **dadurch gekennzeichnet, dass** die Dicke der Oberflächenschicht aus einem halbleitendem Substrat (12) unterhalb der grabenförmigen Driftregion (29, 30, 33) in einem Bereich zwischen der Hälfte und einem Faktor Fünf der Tiefe der grabenförmigen Driftregion (29, 30, 33) liegt.

19. Verfahren nach Anspruch 18, **dadurch gekennzeichnet, dass** es innerhalb eines Verfahrens zur Herstellung eines DMOS-Transistors mit einem Halbleiterkörper (10) verwendet wird, der eine Oberflächenschicht aus einem halbleitendem Substrat (12) mit einem Source-Bereich (56) und einem Drain-Bereich (46) eines zweiten Leitfähigkeitstyps und einen ersten, den Source-Bereich (56) umschließenden Wannenbereich (16) eines ersten Leitfähigkeitstyps und einen zweiten, den Drain-Bereich (46) umschließenden Wannenbereich (18) eines zweiten Leitfähigkeitstyps aufweist, und auf der Oberfläche der Oberflächenschicht aus einem halbleitendem Substrat (12) des Halbleiterkörpers (10) ein Gate-Bereich (44) ausgebildet ist, der sich beginnend von dem Source-Bereich (56) vollständig über den ersten Wannenbereich (16) erstreckt, wobei die grabenförmigen Driftregion (29, 30, 33) ausgehend von der Oberfläche des Halbleiterkörpers (5) in der Oberflächenschicht aus einem halbleitendem Substrat (12) erzeugt wird, und im Bodenbereich (30) der grabenförmigen Struktur eine Dotierung des zweiten Leitfahigkeitstyps erzeugt wird, und in dem Source-seitigen Seitenbereich (29) der grabenförmigen Driftregion (29, 30, 33) eine Dotierung des zweiten Leitfähigkeitstyps mit einem zweiten Konzentrationswert erzeugt wird, und in dem Drain-seitigen Seitenbereich (33) der grabenförmigen Driftregion (29, 30, 33) eine Dotierung des zweiten Leitfähigkeitstyps mit einer dritten Konzentrationswert erzeugt wird.
